(19) Europäisches Patentamt
European Patent Office
Office européen des brevets

(11) EP 2 190 028 A1

(12) EUROPEAN PATENT APPLICATION
published in accordance with Art. 153(4) EPC

(43) Date of publication:
**26.05.2010 Bulletin 2010/21**

(21) Application number: **09725180.5**

(22) Date of filing: **07.01.2009**

(51) Int Cl.:
***H01L 31/04*** *(2006.01)*

(86) International application number:
**PCT/JP2009/050098**

(87) International publication number:
**WO 2009/119125 (01.10.2009 Gazette 2009/40)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **28.03.2008 JP 2008088596**

(71) Applicant: **Mitsubishi Heavy Industries, Ltd.**
**Tokyo 108-8215 (JP)**

(72) Inventors:
- **SAKAI, Satoshi**
**Yokohama-shi**
**Kanagawa 236-8515 (JP)**
- **ASAHARA, Yuji**
**Yokohama-shi**
**Kanagawa 236-8515 (JP)**
- **KOBAYASHI, Yasuyuki**
**Yokohama-shi**
**Kanagawa 236-8515 (JP)**
- **MORI, Masafumi**
**Nagasaki-shi**
**Nagasaki 851-0392 (JP)**
- **TSURUGA, Shigenori**
**Yokohama-shi**
**Kanagawa 236-8515 (JP)**
- **YAMASHITA, Nobuki**
**Nagasaki-shi**
**Nagasaki 851-0392 (JP)**

(74) Representative: **Henkel, Feiler & Hänzel**
**Patentanwälte**
**Maximiliansplatz 21**
**80333 München (DE)**

(54) **PHOTOELECTRIC CONVERTER**

(57) The short-circuit current of a photovoltaic device is improved by optimizing the transparent conductive layer. A photovoltaic device 100 comprising a first transparent electrode layer 2, an electric power generation layer 3, a second transparent electrode layer 6 and a back electrode layer 4 on a substrate 1, wherein the film thickness of the second transparent electrode layer 6 is not less than 80 nm and not more than 100 nm, and the light absorptance for the second transparent electrode layer 6 in a wavelength region from not less than 600 nm to not more than 1,000 nm is not more than 1.5%. Also, a photovoltaic device 100 wherein the film thickness of the second transparent electrode layer 6 is not less than 80 nm and not more than 100 nm, and the reflectance for light reflected at the second transparent electrode layer 6 and the back electrode layer 4 is not less than 91% in the wavelength region from not less than 600 nm to not more than 1,000 nm.

FIG. 1

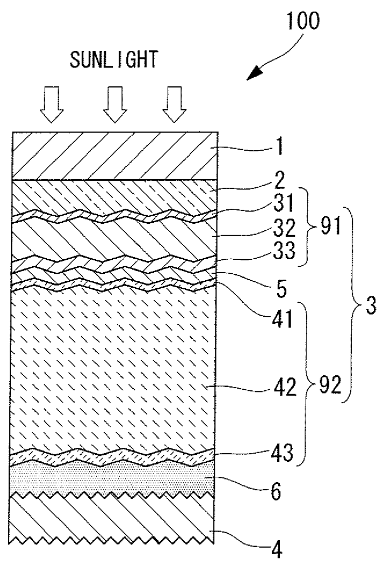


EP 2 190 028 A1

## Description

### Technical Field

The present invention relates to a photovoltaic device, and relates particularly to a solar cell that uses silicon as the electric power generation layer.

### Background Art

The use of solar cells as photovoltaic devices that receive light and convert the energy into electrical power is already known. Amongst solar cells, thin-film type solar cells in which thin films of silicon-based layers are stacked together to form an electric power generation layer (photovoltaic layer) offer various advantages, including the comparative ease with which the surface area can be increased, and the fact that the film thickness is approximately 1/100th that of a crystalline solar cell, meaning minimal material is required. As a result, thin-film silicon-based solar cells can be produced at lower cost than crystalline solar cells. However, a drawback of thin-film silicon-based solar cells is the fact that the conversion efficiency is lower than that of crystalline solar cells.

In thin-film solar cells, various innovations have been adopted to improve the conversion efficiency, namely the electrical power output. For example, tandem-type solar cells have been proposed in which two photovoltaic cells having different wavelength absorption bands are stacked together, thereby enabling a more efficient absorption of the incident light in order to yield a higher electric power generation efficiency. In such a case, long-wavelength light having a wavelength of 600 nm to 1,000 nm is absorbed by crystalline silicon within the photovoltaic cell, but because the absorption coefficient for the crystalline silicon within this long-wavelength band is small, the incident light must be reflected inside the solar cell to lengthen the light path and increase the quantity of light absorbed by the crystalline silicon. Accordingly, in the case of super straight-type solar cells, where the sunlight enters the cell from the side of the transparent substrate, investigations continue to be conducted into improving the structure of the back surface on the opposite side of the electric power generation layer to the light-incident side.

Patent citation 1 discloses a back surface structure in which the back electrode is formed of a metal that exhibits a high reflectance for light in the wavelength band corresponding with the radiation spectrum of sunlight, and a transparent conductive layer is formed between the back electrode and the silicon semiconductor layer. By forming this transparent conductive layer, alloying of the material of the back electrode and the silicon thin films can be prevented, meaning the high reflectance of the back electrode can be maintained and any decrease in the conversion efficiency can be prevented.

Patent Citation 1: Japanese Examined Patent Application, Publication No. Sho 60-41878

### Disclosure of Invention

The deposition conditions for the above transparent conductive layer have yet to be optimized, and problems remain with the internal transparency of the transparent conductive layer. Conventionally, when setting the deposition conditions for the transparent conductive layer, the conductivity has generally tended to be emphasized at the expense of the internal transparency. It is well known that the conductivity and the internal transparency are opposing phenomena. When a transparent conductive layer is formed, light absorption by the transparent conductive layer represents a loss that causes a decrease in the short-circuit current of the solar cell. As a result, improving the transparency of the transparent conductive layer, thereby increasing the short-circuit current of the solar cell, has become an important issue.

The present invention has an object of improving the short-circuit current of a photovoltaic device by optimizing the transparent conductive layer.

In order to achieve the above object, a photovoltaic device of the present invention comprises a first transparent electrode layer, an electric power generation layer, a second transparent electrode layer and a back electrode layer on a substrate, wherein the film thickness of the second transparent electrode layer is not less than 80 nm and not more than 100 nm, and the light absorptance for the second transparent electrode layer in a wavelength region from not less than 600 nm to not more than 1,000 nm is not more than 1.5%.

When the film thickness of the second transparent electrode layer is increased, the separation between the electric power generation layer and the back electrode layer is increased, and therefore light absorption at the surface of the back electrode layer can be suppressed. The reason for this observation is that as the film thickness of the second transparent electrode layer is increased, the electric field strength distribution of light penetrating into the interior of the back electrode layer becomes smaller and shallower, and the quantity of light absorption at the back electrode layer decreases. On the other hand, because conventional second transparent electrode layers have a large light absorptance, when the film thickness of the second transparent electrode layer is increased, the quantity of light reflecting off the back electrode layer and reaching the electric power generation layer is reduced.

As a result of investigating the optimal film thickness and optical properties for the second transparent electrode layer, it was discovered that by producing a photovoltaic device in which the film thickness of the second transparent electrode layer was not less than 80 nm and not more than 100 nm, and the light absorptance for the second transparent electrode layer in a wavelength region from not less than 600 nm to not more than 1,000 nm was not more than 1.5%, light absorption at the surface of the back electrode layer could be reduced, and light absorption by the second transparent electrode layer could also be reduced. As a result, the quantity of light absorbed by the electric power generation layer could be increased, enabling the short-circuit current at the electric power generation layer to be increased.

Furthermore, a photovoltaic device of another aspect of the present invention comprises a first transparent electrode layer, an electric power generation layer, a second transparent electrode layer and a back electrode layer on a substrate, wherein the film thickness of the second transparent electrode layer is not less than 80 nm and not more than 100 nm, and the reflectance for light reflected at the interface between the second transparent electrode layer and the electric power generation layer, and at the interface between the second transparent electrode layer and the back electrode layer is not less than 91% in the wavelength region from not less than 600 nm to not more than 1,000 nm.

As a result of investigating the optimal film thickness and optical properties for the second transparent electrode layer, it was discovered that by producing a photovoltaic device in which, as described above, the film thickness of the transparent electrode layer was not less than 80 nm and not more than 100 nm, and the reflectance for light reflected at the interface between the second transparent electrode layer and the electric power generation layer, and at the interface between the second transparent electrode layer and the back electrode layer was not less than 91% in the wavelength region from not less than 600 nm to not more than 1,000 nm, light absorption at the surface of the back electrode layer could be reduced, and light absorption by the second transparent electrode layer could also be reduced. As a result, the short-circuit current at the electric power generation layer could be increased.

In the present invention, the electric power generation layer preferably comprises a crystalline silicon i-layer. Crystalline silicon absorbs light in the wavelength region from 600 nm to 1,000 nm. Accordingly, in the wavelength region from not less than 600 nm to not more than 1,000 nm, if the light absorptance for the second transparent electrode layer is not more than 1.5%, or the reflectance for light reflected by the second transparent electrode layer and the back electrode layer is not less than 91%, then the quantity of light absorbed by the crystalline silicon can be increased, enabling the short-circuit current for the photovoltaic device to be further improved.

In this case, the electric power generation layer may comprise two or more cell layers, and at least one intermediate contact layer may be provided between one of the cell layers and another of the cell layers that is closest to said one of the first cell layers.

The intermediate contact layer has a light containment-enhancing effect. By providing the intermediate contact layer, the quantity of light reflected from the back electrode layer and the second transparent electrode layer can be increased, thereby enhancing the improvement in the short-circuit current.

In the present invention, the electric power generation layer preferably comprises a single cell layer, wherein that cell layer comprises an amorphous silicon i-layer, and the light absorptance for the second transparent electrode layer in a wavelength region from not less than 600 nm to not more than 800 nm is not more than 1.0%.

Amorphous silicon absorbs light in the wavelength region from 600 nm to 1,000 nm. In a photovoltaic device described above, comprising a single cell layer in which the electric power generation layer has an amorphous silicon i-layer, if the light absorptance for the second transparent electrode layer is not more than 1.0% in the wavelength region from not less than 600 nm to not more than 800 nm, then the quantity of light absorbed by the amorphous silicon can be increased. As a result, the short-circuit current for the photovoltaic device can be increased.

In the present invention, the electric power generation layer preferably comprises a single cell layer, wherein that cell layer comprises an amorphous silicon i-layer, and the reflectance for light reflected at the interface between the second transparent electrode layer and the electric power generation layer, and at the interface between the second transparent electrode layer and the back electrode layer is not less than 91% in the wavelength region from not less than 600 nm to not more than 800 nm. By adopting this structure for a photovoltaic device comprising a single cell layer in which the electric power generation layer has an amorphous silicon i-layer, the quantity of light absorbed by the amorphous silicon can be increased, and the short-circuit current of the photovoltaic device can be increased.

In the present invention, the back electrode layer preferably comprises one or more types of thin film selected from among a silver thin film, aluminum thin film, gold thin film and copper thin film.

The thin films listed above all exhibit high reflectance, and therefore increase the quantity of light absorbed by the electric power generation layer, enabling an increase in the short-circuit current at the electric power generation layer.

In a photovoltaic device according to one aspect of the present invention, the film thickness of the second transparent electrode layer is not less than 80 nm and not more than 100 nm, and the light absorptance for the second transparent electrode layer in a wavelength region from not less than 600 nm to not more than 1,000 nm is not more than 1.5%, and consequently the quantity of light absorption at the electric power generation layer increases, yielding a photovoltaic device having a high short-circuit current.

In a photovoltaic device according to another aspect of the present invention, the film thickness of the second transparent electrode layer is not less than 80 nm and not more than 100 nm, and the reflectance for light reflected at the interface between the second transparent electrode layer and the electric power generation layer, and at the interface between the second transparent electrode layer and the back electrode layer is not less than 91% in the wavelength region from not less than 600 nm to not more than 1,000 nm, and consequently the quantity of light absorption at the electric power generation layer increases, yielding a photovoltaic device having a high short-circuit current.

Brief Description of Drawings

[FIG. 1] A cross-sectional view schematically illustrating the structure of a photovoltaic device according to an embodiment of the present invention.
[FIG. 2] A schematic illustration describing an embodiment for producing a solar cell panel that represents a photovoltaic device according to the present invention.
[FIG. 3] A schematic illustration describing an embodiment for producing a solar cell panel that represents a photovoltaic device according to the present invention.
[FIG. 4] A schematic illustration describing an embodiment for producing a solar cell panel that represents a photovoltaic device according to the present invention.
[FIG. 5] A schematic illustration describing an embodiment for producing a solar cell panel that represents a photovoltaic device according to the present invention.
[FIG. 6] Sample calculations of the absorption spectrum for a structural model 1 in which a GZO film having a small light absorptance is formed.
[FIG. 7] Sample calculations of the absorption spectrum for a structural model 1 in which a GZO film having a medium light absorptance is formed.
[FIG. 8] Sample calculations of the absorption spectrum for a structural model 1 in which a GZO film having a large light absorptance is formed.
[FIG. 9] Sample calculations of the reflectance spectrum for a structural model 2 in which a GZO film having a small light absorptance is formed.
[FIG. 10] Sample calculations of the reflectance spectrum for a structural model 2 in which a GZO film having a medium light absorptance is formed.
[FIG. 11] Sample calculations of the reflectance spectrum for a structural model 2 in which a GZO film having a large light absorptance is formed.
[FIG. 12] A diagram showing a structural model 3 used in optical thin film calculations.
[FIG. 13] A graph illustrating the relationship between the film thickness and the reflectance of the second transparent electrode layer at a wavelength of 600 nm.
[FIG. 14] A graph illustrating the relationship between the film thickness and the reflectance of the second transparent electrode layer at a wavelength of 800 nm.
[FIG. 15] A graph illustrating the relationship between the film thickness and the reflectance of the second transparent electrode layer at a wavelength of 1,000 nm.
[FIG. 16] A graph illustrating the relationship between the film thickness of the second transparent electrode layer and the relative value for the short-circuit current of an amorphous silicon solar cell.
[FIG. 17] A graph illustrating the relationship between the film thickness of the second transparent electrode layer and the relative value for the short-circuit current of a tandem-type solar cell.

Explanation of Reference:

1: Substrate
2: First transparent electrode layer
3: Photovoltaic layer
4: Back electrode layer
5: Intermediate contact layer
6: Second transparent electrode layer
7: Solar cell module
31: Amorphous silicon p-layer
32: Amorphous silicon i-layer
33: Amorphous silicon n-layer
41: Crystalline silicon p-layer
42: Crystalline silicon i-layer
43: Crystalline silicon n-layer
91: First cell layer
92: Second cell layer
100: Photovoltaic device

Best Mode for Carrying Out the Invention

A description of the structure of an embodiment of a photovoltaic device of the present invention is presented below.
FIG. 1 is a schematic illustration of the structure of a photovoltaic device according to this embodiment. A photovoltaic device 100 is a silicon-based solar cell, and comprises a substrate 1, a first transparent electrode layer 2, a first cell layer 91 (an amorphous silicon series) and a second cell layer 92 (a crystalline silicon series) that function as a photovoltaic layer 3, and a second transparent electrode layer 6 and a back electrode layer 4 that function as the back surface structure. Here, the terms "silicon-based" and "silicon series" are generic terms that include silicon (Si), silicon carbide (SiC) and silicon germanium (SiGe). Further, a crystalline silicon series describes a silicon series other than an amorphous silicon series, and includes both microcrystalline silicon series and polycrystalline silicon series.
A description of the steps for producing a photovoltaic device according to the present embodiment is presented below, using a solar cell panel as an example, with reference to FIG. 2 through FIG. 5.

(1) FIG. 2(a)

A soda float glass substrate (for example, a large surface area substrate of 1.4 m × 1.1 m × thickness: 3 to 6 mm, where the length of one side exceeds 1 m) is used as the substrate 1. The edges of the substrate are preferably subjected to corner chamfering or R-face chamfering to prevent damage caused by thermal stress or impacts or the like.

(2) FIG. 2(b)

A transparent electrode film comprising mainly tin oxide ($SnO_2$) and having a film thickness of approximately not less than 500 nm and not more than 800 nm is deposited as the first transparent electrode layer 2, using a thermal CVD apparatus at a temperature of approximately 500°C. During this deposition, a texture comprising suitable unevenness is formed on the surface of the transparent electrode film. In addition to the transparent electrode film, the first transparent electrode layer 2 may include an alkali barrier film (not shown in the figure) formed between the substrate 1 and the transparent electrode films. The alkali barrier film is formed using a thermal CVD apparatus at a temperature of approximately 500°C to deposit a silicon oxide film ($SiO_2$) having a film thickness of not less than 50 nm and not more than 150 nm.

(3) FIG. 2(c)

Subsequently, the substrate 1 is mounted on an X-Y table, and the first harmonic of a YAG laser (1064 nm) is irradiated onto the surface of the first transparent electrode layer, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

(4) FIG. 2(d)

Using a plasma enhanced CVD apparatus, a p-layer, an i-layer and an n-layer, each composed of a thin film of amorphous silicon, are deposited as the first cell layer 91. Using $SiH_4$ gas and $H_2$ gas as the main raw materials, and under conditions including a reduced pressure atmosphere of not less than 30 Pa and not more than 1,000 Pa and a substrate temperature of approximately 200°C, an amorphous silicon p-layer 31, an amorphous silicon i-layer 32 and an amorphous silicon n-layer 33 are deposited, in this order, on the first transparent electrode layer 2, with the p-layer closest to the surface from which incident sunlight enters. The amorphous silicon p-layer 31 is an amorphous B-doped silicon film having a film thickness of not less than 10 nm and not more than 30 nm. The amorphous silicon i-layer 32 has a film thickness of not less than 200 nm and not more than 350 nm. The amorphous silicon n-layer 33 is a P-doped amorphous silicon film having a film thickness of not less than 30 nm and not more than 50 nm. Either a crystalline silicon film or a stacked structure of an amorphous silicon film and a crystalline silicon film may be formed instead of the amorphous silicon n-layer 33. A buffer layer may be provided between the amorphous silicon p-layer 31 and the amorphous silicon i-layer 32 in order to improve the interface properties.

Using a plasma enhanced CVD apparatus, a p-layer, an i-layer and an n-layer, each composed of a thin film of crystalline silicon, are deposited as the second cell layer 92 on top of the first cell layer 91. Using $SiH_4$ gas and $H_2$ gas as the main raw materials, and under conditions including a reduced pressure atmosphere of not more than 3,000 Pa, a substrate temperature of approximately 200°C and a plasma generation frequency of not less than 40 MHz and not more than 100 MHz, a crystalline silicon p-layer 41, a crystalline silicon i-layer 42 and a crystalline silicon n-layer 43 are deposited in this order.

The crystalline silicon p-layer 41 is a B-doped crystalline silicon film having a film thickness of not less than 10 nm and not more than 50 nm. The crystalline silicon i-layer 42 has a film thickness of not less than 1.2 μm and not more than 3.0 μm. The crystalline silicon n-layer 43 is a P-doped crystalline silicon film having a film thickness of not less than 20 nm and not more than 50 nm.

In this embodiment, an intermediate contact layer 5 that functions as a semi-reflective film for improving the contact properties between the first cell layer 91 and the second cell layer 92 and achieving electrical current consistency may be provided on the first cell layer 91. For example, a GZO (Ga-doped ZnO) film with a film thickness of not less than 20 nm and not more than 100 nm may be deposited as the intermediate contact layer 5 using a DC sputtering apparatus with a Ga-doped ZnO sintered body as the target.

(5) FIG. 2(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to not less than 10 kHz and not more than 20 kHz, the laser power is adjusted so as to achieve a suitable process speed, and laser etching is conducted at a point approximately 100 μm to 150 μm to the side of the laser etching line within the first transparent electrode layer 2, so as to form a slot 11. The laser may also be irradiated from the side of the substrate 1. In this case, because the high vapor pressure generated by the energy absorbed by the first cell layer 91 of the photovoltaic layer 3 can be utilized, more stable laser etching processing can be performed. The position of the laser etching line is determined with due consideration of positioning tolerances, so as not to overlap with the previously formed etching line.

(6) FIG. 3(a)

The second transparent electrode layer 6 and the back electrode layer 4 are formed sequentially on top of the crystalline silicon n-layer 43 of the second cell layer 92.

Using a sputtering apparatus, a GZO film is deposited as the second transparent electrode layer 6, using a Ga-doped ZnO sintered body as the target, and under conditions including a discharge gas composed of argon and oxygen, an oxygen partial pressure of not less than 0.5% and not more than 2%, and a substrate temperature of not less than 20°C and not more than 200°C. The film thickness of the second transparent electrode layer 6 is typically not less than 80 nm and not more than 100 nm, and is preferably not less than 90 nm and not more than 100 nm. In this embodiment, by depositing the GZO film while introducing oxygen in this manner, the transparency of the second transparent electrode layer 6 is improved.

An appropriate value for the oxygen partial pressure can be set by measuring the absorptance and conductivity of the second transparent electrode layer. In other words, if the oxygen partial pressure is too high, then although the absorptance decreases, the conductivity deteriorates, and the layer is unable to function as a transparent electrode layer. If the oxygen partial pressure is too low, then although the conductivity is favorable, the absorptance deteriorates.

The film thickness of the second transparent electrode layer of a solar cell is measured by exposing a cross-section of the solar cell using slicing, polishing or focused ion beam (FIB) processing or the like, and then inspecting the cross-section using a scanning electron microscope (SEM) or a transmission electron microscope (TEM).

Using a sputtering apparatus, a silver thin film is deposited as the back electrode layer 4, using Ag as the target and argon as the discharge gas, and at a deposition temperature of approximately 150°C. Alternatively, a silver thin film/titanium thin film stacked structure, formed by sequentially stacking a silver thin film having a thickness of 200 to 500 nm, and a highly corrosion-resistant titanium thin film having a thickness of 10 to 20 nm which acts as a protective film, may be formed as the back electrode layer 4. In this case, the silver thin film is provided on the substrate-side of the stacked structure. An aluminum thin film, gold thin film or copper thin film may also be formed as the back electrode layer 4. Formation of an aluminum thin film is preferred as it enables a significant reduction in the material costs. Further, the back electrode layer may also be formed from a silver thin film/aluminum thin film stacked structure.

In the present embodiment, the absorptance for the second transparent electrode layer 7 in the wavelength region from not less than 600 nm to not more than 1,000 nm is not more than 1.5%, and is preferably 0.2% or less. Furthermore, in the wavelength region from not less than 600 nm to not more than 1,000 nm, the reflectance for light reflected at the interface between the second transparent electrode layer and the electric power generation layer, and at the interface between the second transparent electrode layer and the back electrode layer is not less than 91%, and is preferably 93% or higher.

(7) FIG. 3(b)

The substrate 1 is mounted on an X-Y table, and the second harmonic of a laser diode excited YAG laser (532 nm) is irradiated onto the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 μm to 400 μm to the side of the laser etching line within the transparent electrode layer 2, so as to form a slot 12.

(8) FIG. 3(c)

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). A Y-direction insulation slot need not be provided at this point, because a film surface polishing and removal treatment is conducted on the peripheral regions of the substrate 1 in a later step.

Completing the etching of the insulation slot 15 at a position 5 to 10 mm from the edge of the substrate 1 is preferred, as it ensures that the insulation slot 15 is effective in inhibiting external moisture from entering the interior of the solar cell module 7 via the edges of the solar cell panel.

Although the laser light used in the steps until this point has been specified as YAG laser light, light from a YVO4 laser or fiber laser or the like may also be used in a similar manner.

(9) FIG. 4(a)

In order to ensure favorable adhesion and sealing of a backing sheet 24 via EVA or the like in a subsequent step, the stacked films around the periphery of the substrate 1 (in a peripheral region 14) are removed, as they tend to be uneven and prone to peeling. Grinding or blast polishing or the like is used to remove the back electrode layer 4, the photovoltaic layer 3, and the transparent electrode layer 2 from a region that is 5 mm to 20 mm from the edge around the entire periphery of the substrate 1, is closer to the substrate edge than the insulation slot 15 provided in the above step of FIG. 3(c) in the X direction, and is closer to the substrate edge than the slot 10 near the substrate edge in the Y direction. Grinding debris or abrasive grains are removed by washing the substrate 1.

(10) FIG. 4(b)

A terminal box attachment portion is prepared by providing an open through-window in the backing sheet 24 and exposing a collecting plate. A plurality of layers of an insulating material are provided in this open through-window portion in order to prevent external moisture and the like entering the solar cell module.

Processing is conducted so as to enable current collection, using a copper foil, from the series-connected solar cell electric power generation cell at one end, and the solar cell electric power generation cell at the other end, in order to enable electric power to be extracted from a terminal box portion on the rear surface of the solar cell panel. In order to prevent short circuits between the copper foil and the various portions, an insulating sheet that is wider than the width of the copper foil is provided.

Following arrangement of the collecting copper foil and the like at predetermined positions, the entire solar cell module 7 is covered with a sheet of an adhesive filling material such as EVA (ethylene-vinyl acetate copolymer) arranged so as not to protrude beyond the substrate 1.

A backing sheet 24 with a superior waterproofing effect is positioned on top of the EVA. In this embodiment, in order to achieve a superior waterproofing and moisture-proofing effect, the backing sheet 24 is formed as a three-layer structure comprising a PET sheet, an Al foil, and a PET sheet.

The structure comprising the components up to and including the backing sheet 24 arranged in predetermined positions is subjected to internal degassing under a reduced pressure atmosphere and under pressing at approximately 150°C to 160°C using a laminator, thereby causing cross-linking of the EVA that tightly seals the structure.

(11) FIG. 5(a)

A terminal box 23 is attached to the back of the solar cell module 7 using an adhesive.

(12) FIG. 5(b)

The copper foil and an output cable from the terminal box 23 are connected using solder or the like, and the interior of the terminal box is filled and sealed with a sealant (a potting material). This completes the production of the solar cell panel 50.

(13) FIG. 5(c)

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 $W/m^2$).

(14) FIG. 5(d)

In tandem with the electric power generation test (FIG. 5(c)), a variety of specific performance factors including the external appearance are evaluated.

By forming the second transparent electrode layer with the film thickness described above, the separation between the silicon of the electric power generation layer and the silver thin film of the back electrode layer is increased, and absorption at the silver thin film surface is reduced.

In the solar cell of the present embodiment, the film thickness of the transparent electrode layer is not less than 80 nm and not more than 100 nm. Further, the light absorptance for the second transparent electrode layer in the wavelength region from not less than 600 nm to not more than 1,000 nm is not more than 1.5%, or alternatively, the reflectance for light reflected at the interface between the second transparent electrode layer and the electric power generation layer, and at the interface between the second transparent electrode layer and the back electrode layer is not less than 91% in the wavelength region from not less than 600 nm to not more than 1,000 nm. In this manner, by employing a film thickness for the second transparent electrode layer that is not less than 80 nm and not more than 100 nm, and ensuring a high degree of transparency, the separation between the electric power generation layer and the silver thin film of the back electrode layer is increased, thereby reducing absorption at the silver thin film surface, and light loss within the second transparent electrode layer is reduced. As a result, the quantity of light absorbed by the second cell layer is increased, leading to an increase in the short-circuit current of the solar cell.

In this embodiment, a tandem-type solar cell was presented as an example, but the present invention can also be applied to amorphous silicon single solar cells, crystalline silicon single solar cells, crystalline SiGe single solar cells, and triple-type solar cells.

Particularly in the case of an amorphous silicon single solar cell in which the cell layer has an amorphous silicon i-layer, the light absorptance for the second transparent electrode layer in the wavelength region from not less than 600 nm to not more than 800 nm should be not more than 1.0%, or alternatively, the reflectance for light reflected at the interface between the second transparent electrode layer and the electric power generation layer, and at the interface between the second transparent electrode layer and the back electrode layer should be not less than 91% in the wavelength region from not less than 600 nm to not more than 800 nm.

This ensures that even for an amorphous silicon single solar cell, light loss within the second transparent electrode layer can be reduced. As a result, the quantity of light absorbed by the cell layer is increased, leading to an increase in the short-circuit current of the solar cell.

Examples

(Optical Thin Film Calculations)

Optical thin film interference calculations based on Fresnel reflections were conducted for models having a GZO film for which the light absorption (transparency) exhibited (A) a small light absorptance, (B) a medium light absorptance, or (C) a large light absorptance. OPTAS-FILM from Cybernet Systems Co., Ltd. was used as the calculation software. Data disclosed in existing literature was used as the medium data for the glass and the silver thin film. The medium data for the GZO film was determined by optical measurement of a GZO film formed on glass. Data for monocrystalline Si disclosed in existing literature was used as the medium data for the crystalline silicon. Air was assumed to have a refractive index of 1 and an extinction coefficient of 0.

Absorption spectra were calculated for a structural model (structural model 1) comprising a GZO film exhibiting the light absorption of (A), (B) or (C) formed on top of a glass substrate. The glass substrate and the GZO film were assumed to be smooth. In the structural model 1, light generated on the air-side of the model is irradiated onto the GZO film, with a portion of the light being reflected at the air-side and a portion transmitted through to the glass-side. In the calculations for the structural model 1, light absorption within the GZO film can be determined without including the semi-infinite media that sandwich the GZO film from both sides in the calculations. By using an optical glass of satisfactory transparency as the glass substrate, the absorption spectrum for the structural model 1 can be measured experimentally.

FIG. 6 shows sample calculations of the absorption spectrum for (A) the structural model 1 in which the GZO film has a small light absorptance. FIG. 7 shows sample calculations of the absorption spectrum for (B) the structural model 1 in which the GZO film has a medium light absorptance.

FIG. 8 shows sample calculations of the absorption spectrum for (C) the structural model 1 in which the GZO film has a large light absorptance. In each of FIGS. 6 to 8, the horizontal axis represents the wavelength and the vertical axis represents the absorptance. The absorptance $\alpha$ (%) is determined from formula (1) shown below, after first using optical thin film calculations to determine the reflectance R (%) and the transmittance T (%) when light is incident from the air layer on the GZO film side of the model.

$$\alpha = 100-(R+T) \qquad (1)$$

As shown in FIG. 6, in the case of (A) the GZO film having a small light absorptance, the light absorptance in the wavelength region from not less than 600 nm to not more than 1,000 nm was not more than 0.2% for a film thickness of 100 nm or less. As shown in FIG. 7, in the case of (B) the GZO film having a medium light absorptance, the light absorptance in the wavelength region from not less than 600 nm to not more than 1,000 nm was not more than 1.5% for a film thickness of 100 nm or less. As shown in FIG. 8, in the case of (C) the GZO film having a large light absorptance, the light absorptance exceeded 1.5% at the long wavelength-side of the spectrum (wavelengths of 950 nm or more) for a film thickness of 50 nm. As the GZO film thickness was increased, the wavelength range for which the absorptance exceeded 1.5% broadened.

Reflectance spectra were calculated for a structural model 2 comprising a GZO film and a silver thin film (film thickness: 300 nm) deposited sequentially on a glass substrate. The glass substrate, the GZO film and the silver thin film were assumed to be smooth. In the structural model 2, light generated on the glass-side of the model is irradiated onto the stacked GZO film and silver thin film, and a portion of the light is reflected at the glass-side. In the calculations for the structural model 2, reflectance by the stacked GZO film and silver thin film can be determined without including the glass absorption in the calculations.

By using an optical glass of satisfactory transparency as the glass substrate, the reflectance spectrum for the structural model 2 can be measured experimentally.

FIG. 9 shows sample calculations of the reflectance spectrum for (A) the structural model 2 in which the GZO film has a small light absorptance. FIG. 10 shows sample calculations of the reflectance spectrum for (B) the structural model 2 in which the GZO film has a medium light absorptance. FIG. 11 shows sample calculations of the reflectance spectrum for (C) the structural model 2 in which the GZO film has a large light absorptance. In each of FIGS. 9 to 11, the horizontal axis represents the wavelength and the vertical axis represents the reflectance.

As shown in FIG. 9, in the case of (A) the GZO film having a small light absorptance, the reflectance in the wavelength region from not less than 600 nm to not more than 1,000 nm was not less than 93% for a film thickness of 100 nm or less. As shown in FIG. 10, in the case of (B) the GZO film having a medium light absorptance, the reflectance in the wavelength region from not less than 600 nm to not more than 1,000 nm was not less than 91% for a film thickness of 100 nm or less. As shown in FIG. 11, in the case of (C) the GZO film having a large light absorptance, the reflectance was significantly reduced when the film thickness was large, and at a film thickness of 70 nm or more, the reflectance was less than 91% within certain wavelength regions.

Reflectance spectra were calculated for a structural model 3 shown in FIG. 12. The structural model 3 of FIG. 12 has a configuration in which a crystalline silicon layer 111 (film thickness: semi-infinite), a GZO film 112, and a silver thin film 113 (film thickness: 300 nm) are stacked sequentially. An air layer 114 is provided on the opposite side of the silver thin film 113 to the GZO film 112. In the structural model 3, light generated on the crystalline silicon layer-side of the model is irradiated onto the stacked GZO film and silver thin film, and a portion of the light is reflected at the crystalline silicon-side. In the calculations for the structural model 3, reflectance by the stacked GZO film and silver thin film can be determined without including the absorption by the crystalline silicon layer in the calculations. The structural model 3 has a similar structure to that of the structural model 2, but the light incident-side medium is different. In other words, because the interface conditions are different when determining the optical thin film interference, the results obtained are completely different. Moreover, in the structural model 3, experimental measurements are impossible in principle, and the reflectance phenomenon can only be ascertained by calculation.

From the reflectance spectra for the structural model in which the GZO film was formed with the absorption described above in (A), (B) or (C), the reflectance values at wavelengths of 600 nm, 800 nm and 1,000 nm were extracted and plotted against the GZO film thickness. FIGS. 13 to 15 are graphs illustrating the relationship between the GZO film thickness and the reflectance at wavelengths of 600 nm, 800 nm and 1,000 nm respectively. In each of these figures, the horizontal axis represents the film thickness, and the vertical axis represents the reflectance.

In the case of (C) the GZO film having a large light absorptance, the film thickness at which the reflectance reached a maximum was within a range from 40 to 70 nm for each wavelength. In contrast, in those cases where the transparency of the GZO film had been improved, namely cases (A) and (B), the GZO film thickness at which the reflectance reached a maximum shifted towards a thicker film for each wavelength.

In the case of (C) the GZO film having a large light absorptance, the maximum reflectance was 97% or less. In contrast, in the case of (B) the GZO film having a medium light absorptance, the reflectance within the wavelength range from not less than 600 nm to not more than 1,000 nm was not less than 97% for a film thickness of not less than 80 nm and not more than 100 nm. Furthermore, in the case of the GZO film having a small light absorptance (A), the reflectance within the wavelength range from not less than 600 nm to not more than 1,000 nm was not less than 98% for a film thickness of not less than 80 nm and not more than 100 nm. In this manner, by improving the transparency of the GZO film, the reflectance was able to be improved.

As a result of the optical thin film calculations, it was discovered that by improving the transparency of the GZO film, the GZO film thickness at which the reflectance reached a maximum was not less than 80 nm and not more than 100 nm, which is thicker than that for a GZO film having a large absorptance. Furthermore, it was also discovered that because light loss within the GZO film can be reduced by improving the transparency of the GZO film, and the separation between the electric power generation layer and the silver thin film is increased by increasing the thickness of the GZO film, thereby reducing absorption at the silver thin film surface, the quantity of light reflected back into the electric power generation layer by the second transparent electrode layer and the back electrode layer could be increased.

(Relationship between film thickness of the second transparent electrode layer and solar cell performance)

An amorphous silicon solar cell was produced by sequentially depositing a first transparent electrode layer, an amorphous silicon p-layer, an amorphous silicon i-layer and an amorphous silicon n-layer as the electric power generation layer, a second transparent electrode layer, and a back electrode layer on a glass substrate. The film thickness of the first transparent electrode layer was 700 nm, the film thickness of the amorphous silicon p-layer was 10 nm, the film thickness of the amorphous silicon i-layer was 200 nm, and the film thickness of the amorphous silicon n-layer was 30 nm. A GZO film was deposited as the second transparent electrode layer using a DC sputtering apparatus, using a Ga-doped ZnO sintered body as the target, and under conditions including a discharge gas composed of argon and oxygen, an oxygen partial pressure of 0.5%, and a substrate temperature of 60°C. Under these deposition conditions, the absorptance of the second transparent electrode layer was not more than 0.2% within the wavelength region from not less than 600 nm to not more than 1,000 nm. A silver thin film having a film thickness of 250 nm was deposited as the back electrode layer using a DC sputtering apparatus, using Ag as the target and argon as the discharge gas, and at a substrate temperature of 135°C. Following formation of the back electrode layer, an annealing treatment was conducted in a nitrogen atmosphere at a temperature of 160°C for a period of 2 hours.

FIG. 16 shows a graph illustrating the relationship between the film thickness of the second transparent electrode layer (the GZO film) and the short-circuit current of the amorphous silicon solar cell. In this figure, the horizontal axis represents the film thickness, and the vertical axis represents the relative value for the short-circuit current referenced against the short-circuit current for a second transparent electrode layer thickness of 40 nm. The values for the short-circuit current represent the average value for measurements conducted at 15 different points on each cell having a 5 cm square substrate surface, across a total of 5 substrates.

For amorphous silicon solar cells in which the film thickness of the second transparent electrode layer was 40 nm or 60 nm, the short-circuit current was substantially equal, but the short-circuit current increased for film thickness values of 80 nm and 100 nm.

A tandem-type solar cell was produced by sequentially depositing a first transparent electrode layer, an electric power generation layer composed of amorphous silicon (a first cell layer), an intermediate contact layer, an electric power generation layer composed of crystalline silicon (a second cell layer), a second transparent electrode layer, and a back electrode layer on a glass substrate. The electric power generation layers were each prepared by depositing a p-layer, an i-layer and an n-layer in sequence from the substrate side.

The film thickness of the first transparent electrode layer was 700 nm. The film thickness of the first cell p-layer was 10 nm, the film thickness of the first cell i-layer was 200 nm, and the film thickness of the first cell n-layer was 30 nm. The film thickness of the intermediate contact layer was 70 nm. The film thickness of the second cell p-layer was 30 nm, the film thickness of the second cell i-layer was 2,000 nm, and the film thickness of the second cell n-layer was 30 nm. A GZO film was deposited as the second transparent electrode layer using a DC sputtering apparatus, using a Ga-doped ZnO sintered body as the target, and under conditions including a discharge gas composed of argon and oxygen, an oxygen partial pressure of 0.5%, and a substrate temperature of 60°C. Under these deposition conditions, the absorptance of the second transparent electrode layer was not more than 0.2% within the wavelength region from not less than 600 nm to not more than 1,000 nm. A silver thin film having a film thickness of 250 nm was deposited as the back electrode layer using a DC sputtering apparatus, using Ag as the target and argon as the discharge gas, and at a substrate temperature of 135°C. Following formation of the back electrode layer, an annealing treatment was conducted in a nitrogen atmosphere at a temperature of 160°C for a period of 2 hours.

FIG. 17 shows a graph illustrating the relationship between the film thickness of the second transparent electrode layer (the GZO film) and the short-circuit current of the tandem-type solar cell. In this figure, the horizontal axis represents the film thickness, and the vertical axis represents the relative value for the short-circuit current referenced against the short-circuit current for a second transparent electrode layer thickness of 40 nm. The values for the short-circuit current represent the average value for measurements conducted at 15 different points on each cell having a 5 cm square substrate surface, across a total of 5 substrates.

Even for tandem-type solar cells, in those cases where the film thickness of the second transparent electrode layer was 40 nm or 60 nm the short-circuit current was substantially equal, but the short-circuit current increased for film thickness values of 80 nm and 100 nm.

In the above examples, the description used solar cells in which a silver thin film was formed as the back electrode layer, but similar effects can be obtained for solar cells in which an aluminum thin film, gold thin film or copper thin film or the like is formed as the back electrode layer.

## Claims

1. A photovoltaic device comprising a first transparent electrode layer, an electric power generation layer, a second transparent electrode layer and a back electrode layer on a substrate, wherein
   a film thickness of the second transparent electrode layer is not less than 80 nm and not more than 100 nm, and
   a light absorptance for the second transparent electrode layer in a wavelength region from not less than 600 nm to not more than 1,000 nm is not more than 1.5%.

2. A photovoltaic device comprising a first transparent electrode layer, an electric power generation layer, a second transparent electrode layer and a back electrode layer on a substrate, wherein
   a film thickness of the second transparent electrode layer is not less than 80 nm and not more than 100 nm, and
   a reflectance for light reflected at an interface between the second transparent electrode layer and the electric power generation layer, and at an interface between the second transparent electrode layer and the back electrode layer is not less than 91% in a wavelength region from not less than 600 nm to not more than 1,000 nm.

3. The photovoltaic device according to Claim 1 or Claim 2, wherein the electric power generation layer comprises a crystalline silicon i-layer.

**4.** The photovoltaic device according to any one of Claim 1 through Claim 3, wherein the electric power generation layer comprises two or more cell layers, and at least one intermediate contact layer is provided between one of the cell layers and another of the cell layers that is closest to said one of the first cell layers.

**5.** The photovoltaic device according to Claim 1, wherein the electric power generation layer comprises a single cell layer, the cell layer comprises an amorphous silicon i-layer, and a light absorptance for the second transparent electrode layer in a wavelength region from not less than 600 nm to not more than 800 nm is not more than 1.0%.

**6.** The photovoltaic device according to Claim 2, wherein the electric power generation layer comprises a single cell layer, the cell layer comprises an amorphous silicon i-layer, and a reflectance for light reflected at an interface between the second transparent electrode layer and the electric power generation layer, and at an interface between the second transparent electrode layer and the back electrode layer is not less than 91% in a wavelength region from not less than 600 nm to not more than 800 nm.

**7.** The photovoltaic device according to any one of Claim 1 to Claim 6, wherein the back electrode layer comprises at least one thin film selected from the group consisting of a silver thin film, an aluminum thin film, a gold thin film and a copper thin film.

FIG. 1

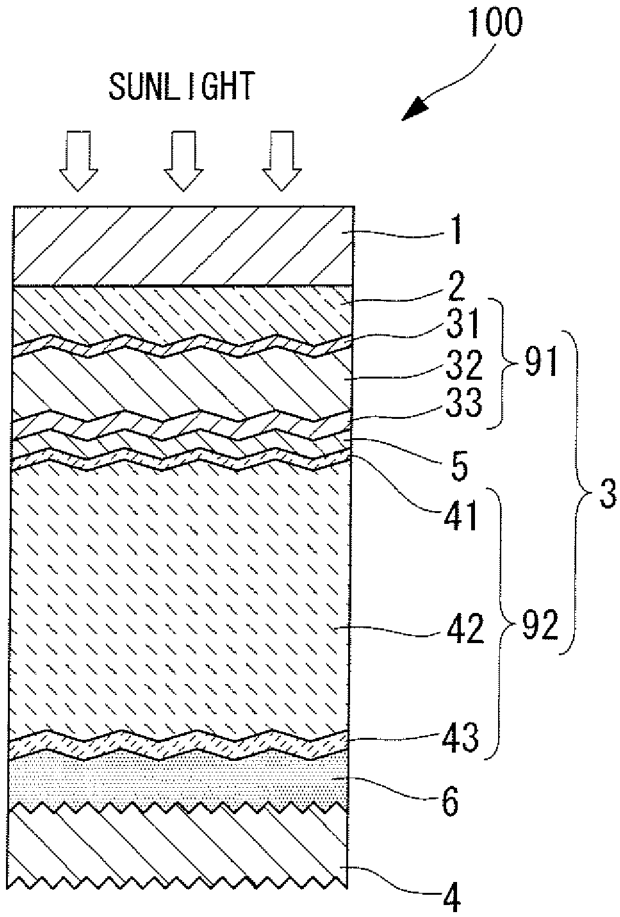

FIG. 2

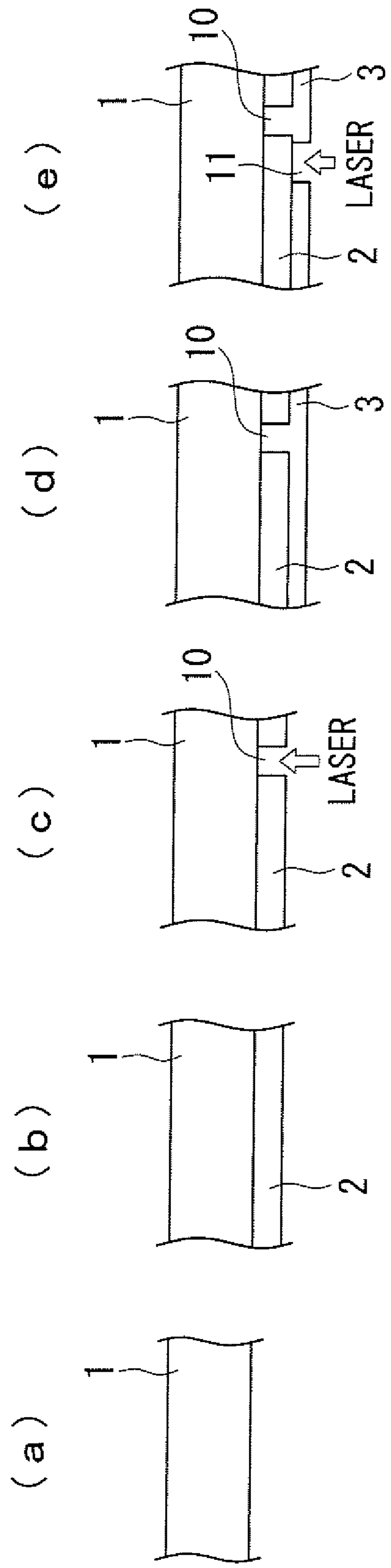

FIG. 3

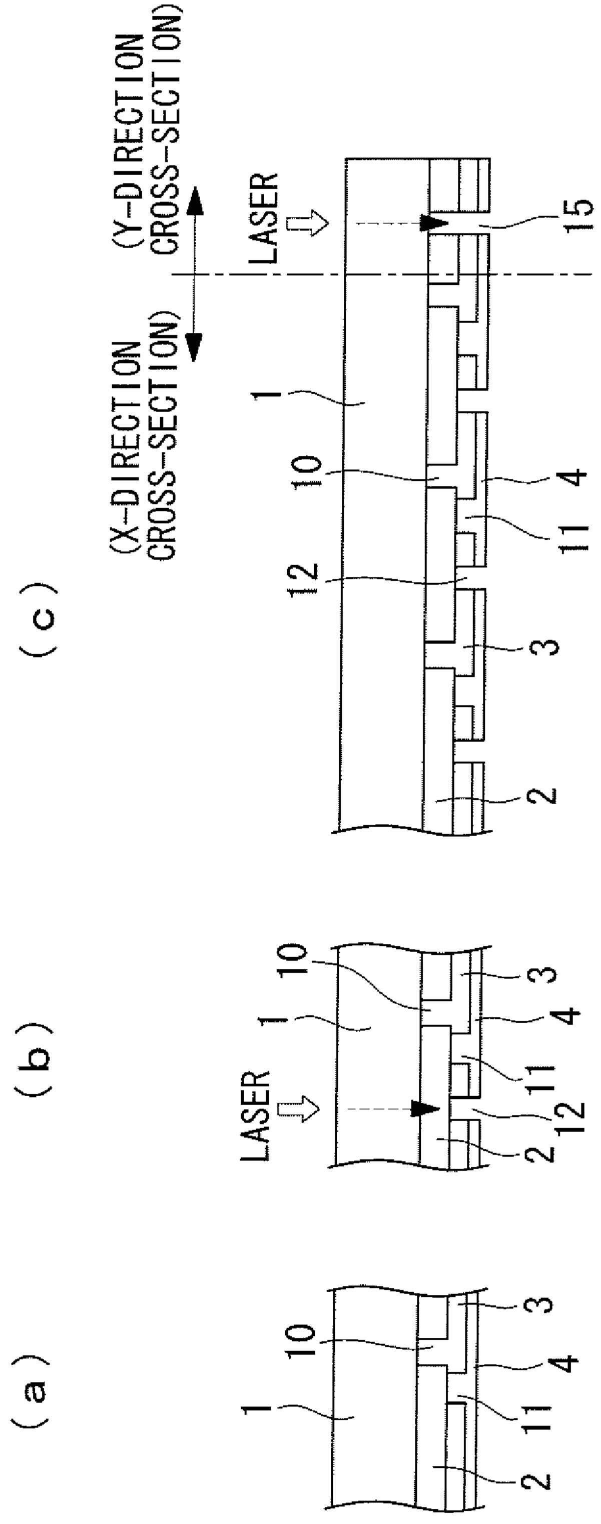
(a)
(b)
(c)
LASER
LASER
(X-DIRECTION CROSS-SECTION)
(Y-DIRECTION CROSS-SECTION)
1
2
3
4
10
11
12
15

FIG. 4

(a)

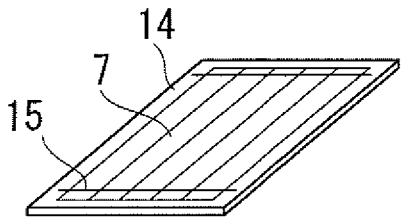


(b)

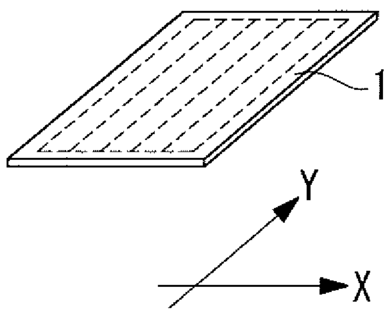

FIG. 5

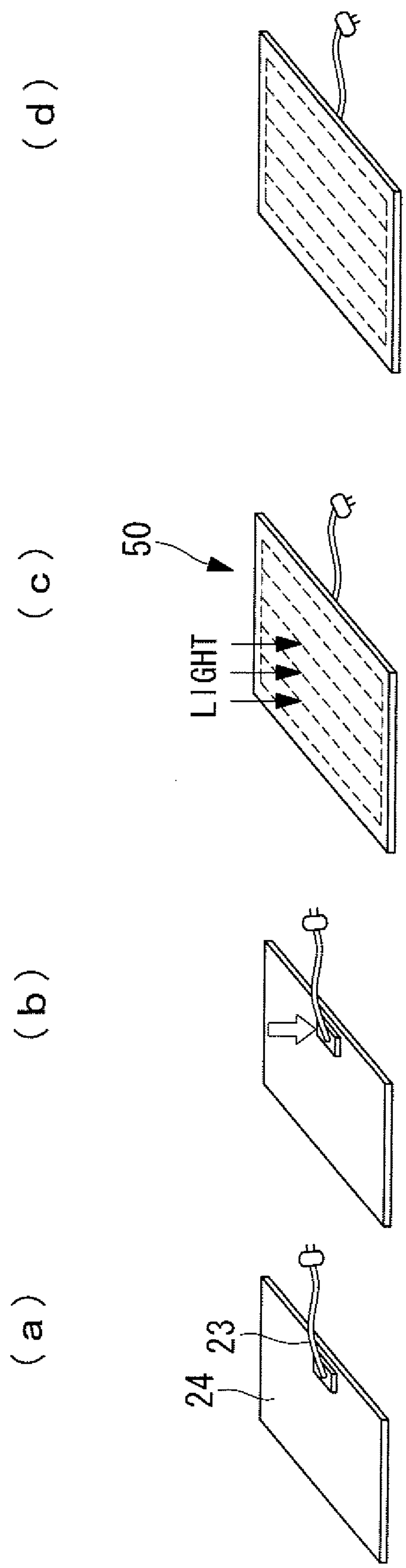

FIG. 6

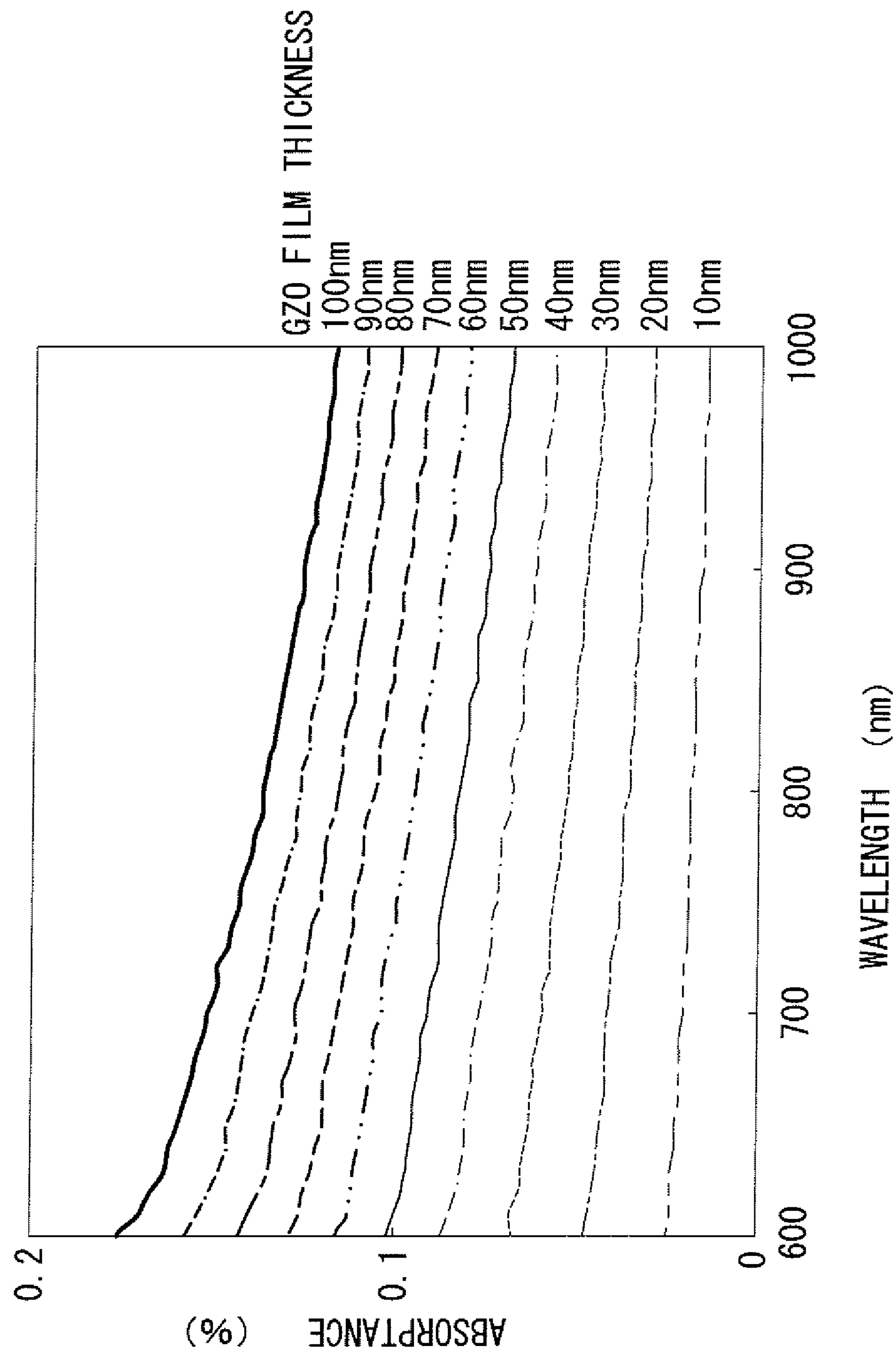
GZO FILM THICKNESS
100nm
90nm
80nm
70nm
60nm
50nm
40nm
30nm
20nm
10nm
ABSORPTANCE (%)
0.2
0.1
0
600
700
800
900
1000
WAVELENGTH (nm)

FIG. 7

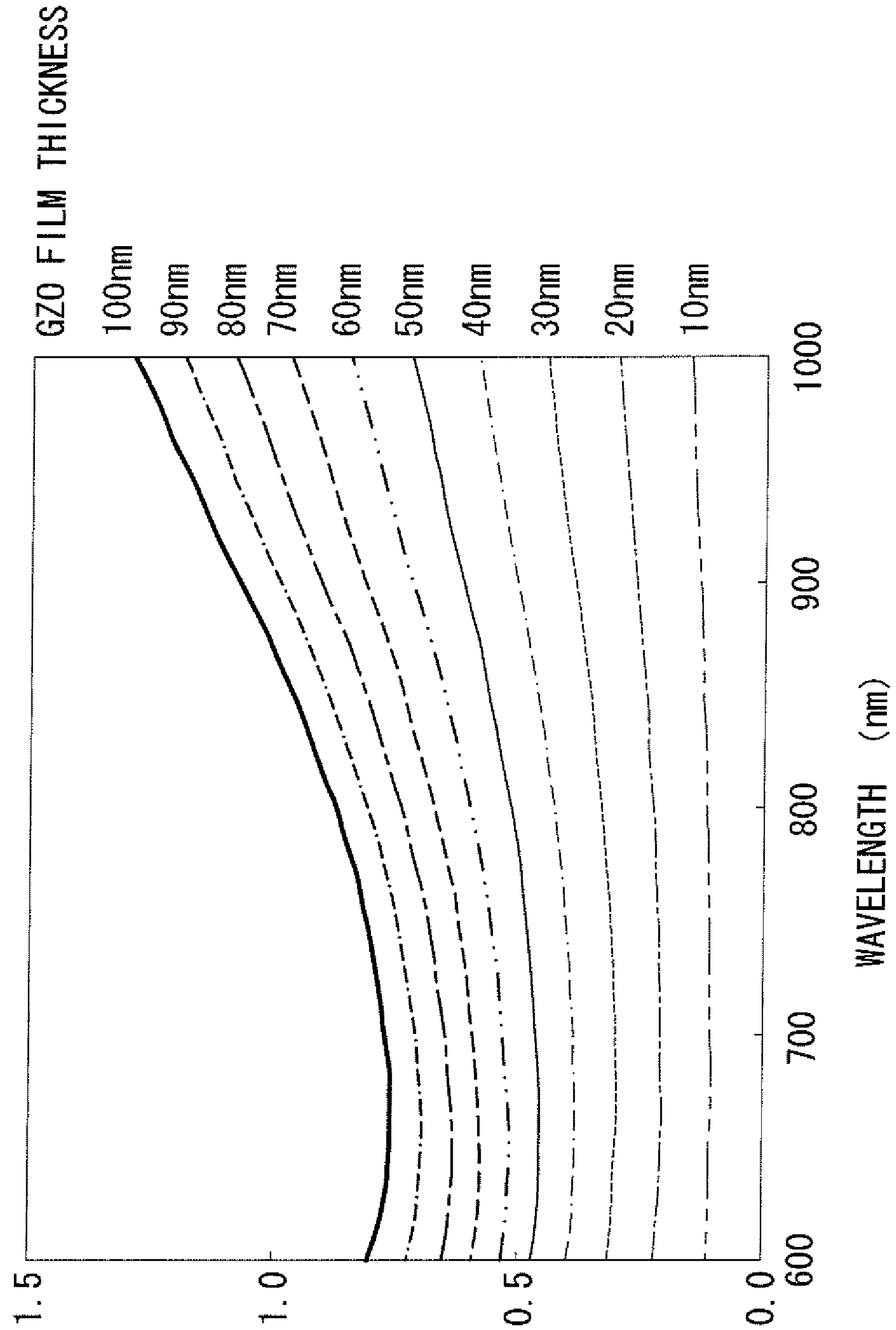
GZO FILM THICKNESS
100nm
90nm
80nm
70nm
60nm
50nm
40nm
30nm
20nm
10nm
ABSORPTANCE (%)
1.5
1.0
0.5
0.0
600
700
800
900
1000
WAVELENGTH (nm)

FIG. 8

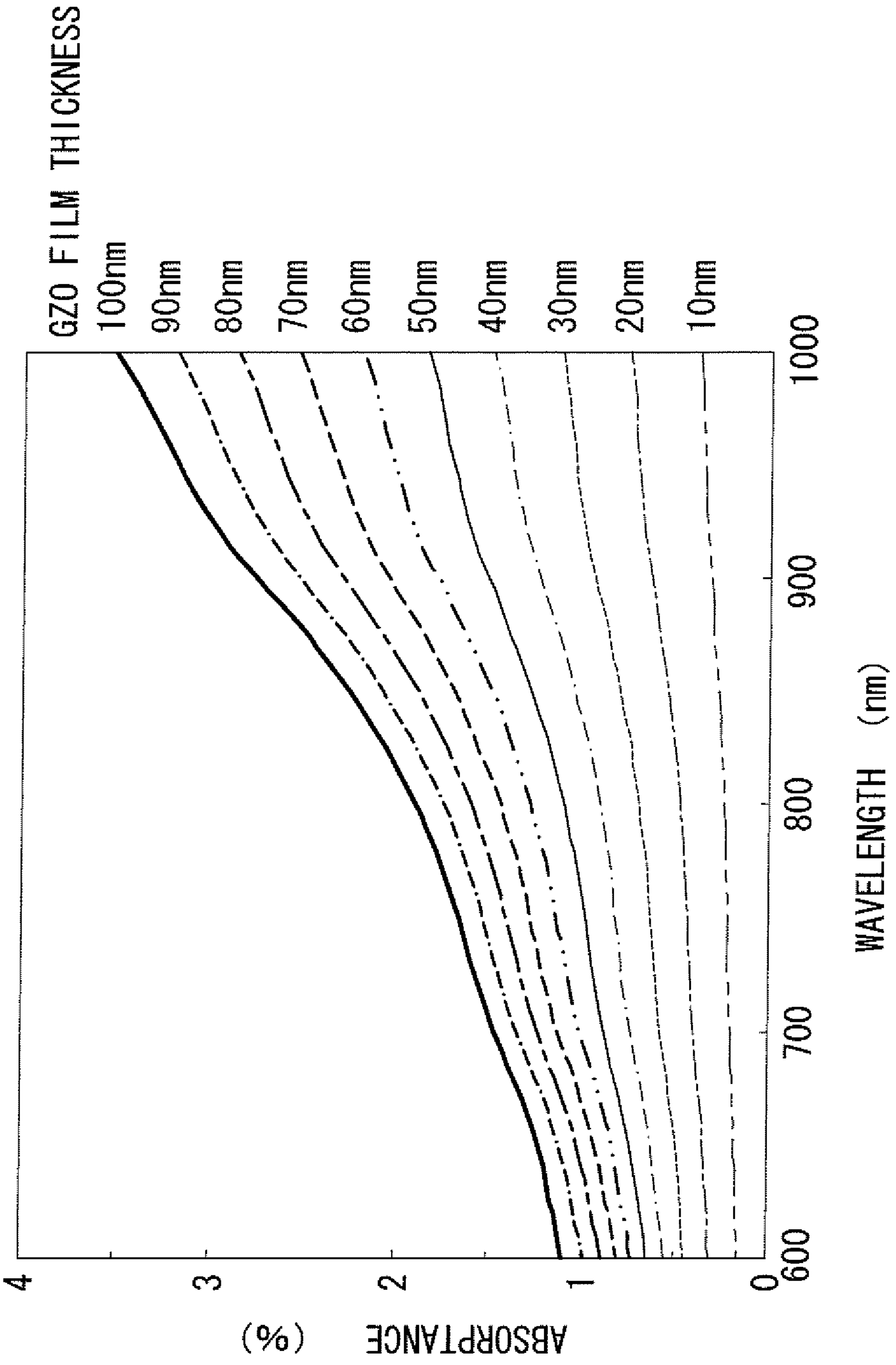
GZO FILM THICKNESS
100nm
90nm
80nm
70nm
60nm
50nm
40nm
30nm
20nm
10nm
ABSORPTANCE (%)
0
1
2
3
4
600
700
800
900
1000
WAVELENGTH (nm)

FIG. 9

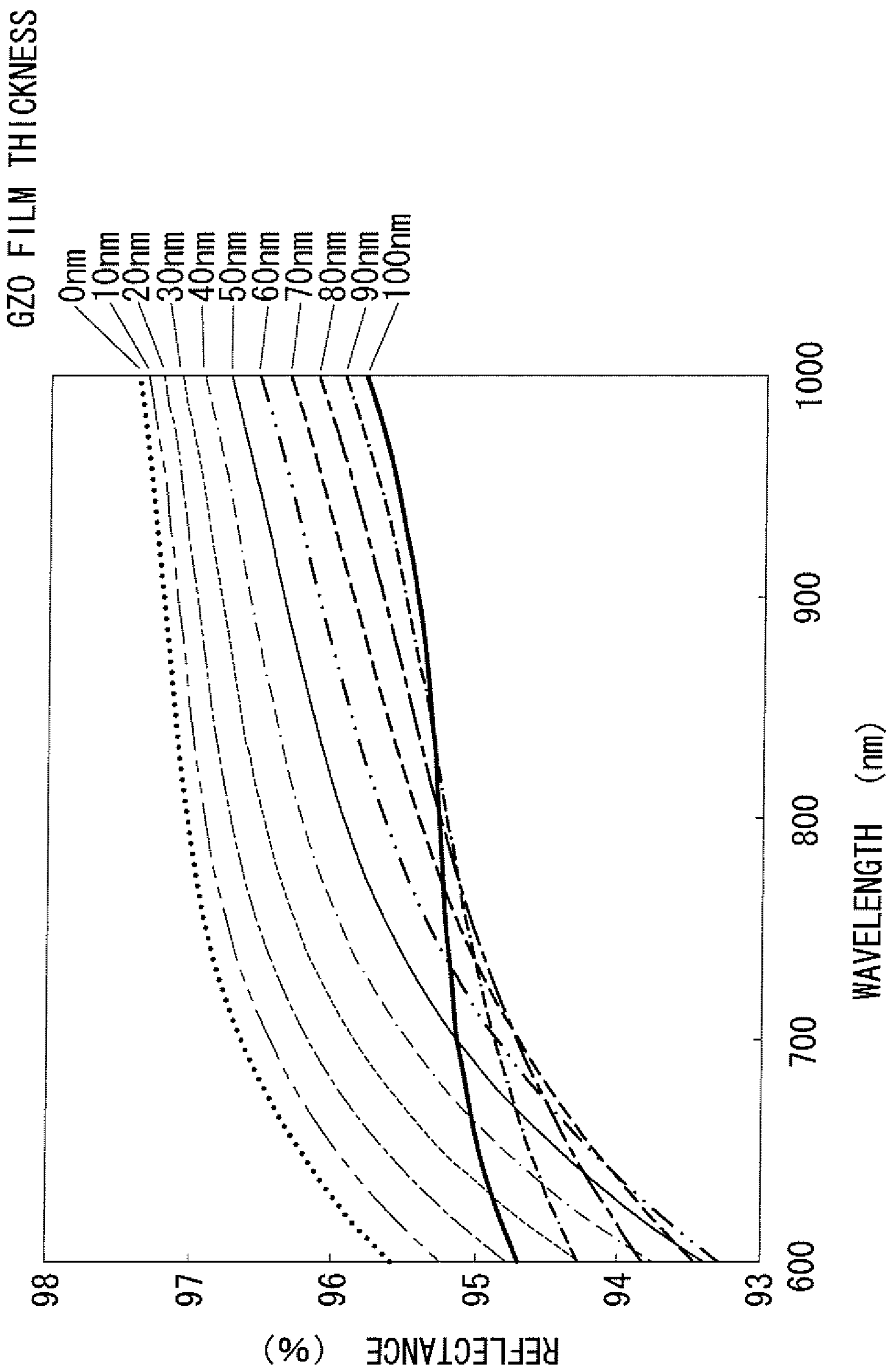
GZO FILM THICKNESS
0nm
10nm
20nm
30nm
40nm
50nm
60nm
70nm
80nm
90nm
100nm
98
97
96
95
94
93
REFLECTANCE (%)
600
700
800
900
1000
WAVELENGTH (nm)

FIG. 10

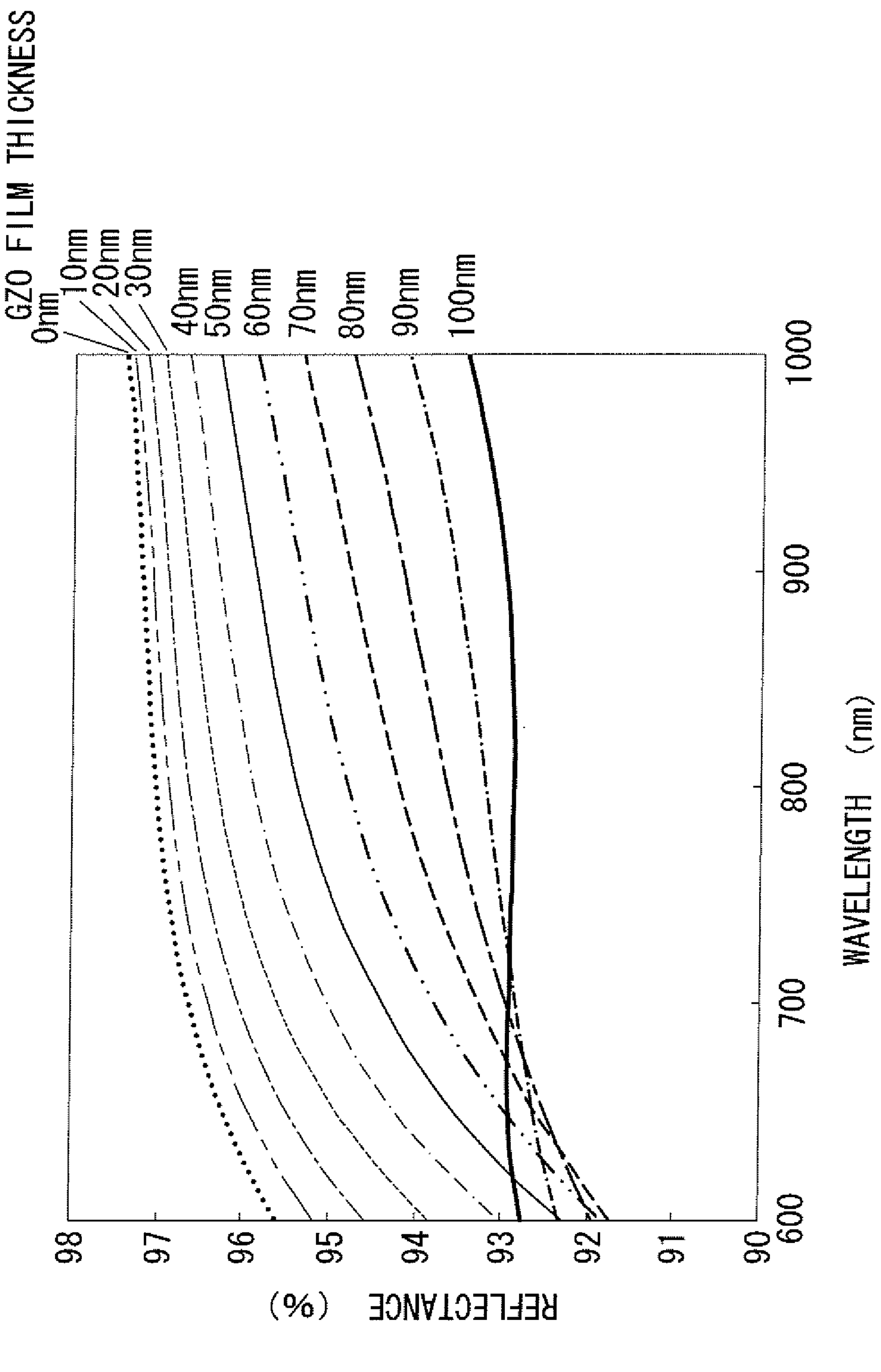
GZO FILM THICKNESS
0nm
10nm
20nm
30nm
40nm
50nm
60nm
70nm
80nm
90nm
100nm
REFLECTANCE (%)
98
97
96
95
94
93
92
91
90
600
700
800
900
1000
WAVELENGTH (nm)

FIG. 11

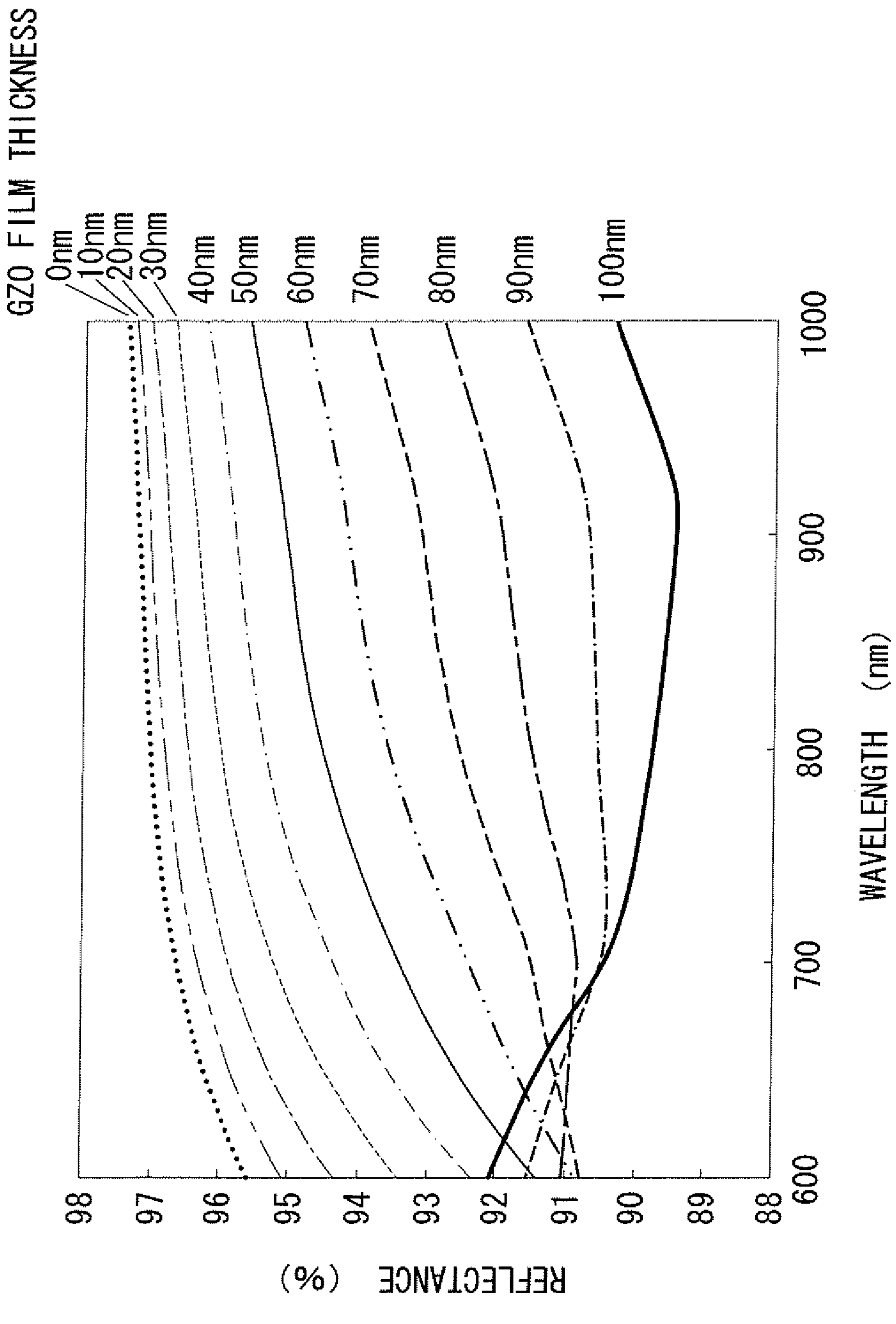
GZO FILM THICKNESS
0nm
10nm
20nm
30nm
40nm
50nm
60nm
70nm
80nm
90nm
100nm
98
97
96
95
94
93
92
91
90
89
88
600
700
800
900
1000
WAVELENGTH (nm)
REFLECTANCE (%)

FIG. 12

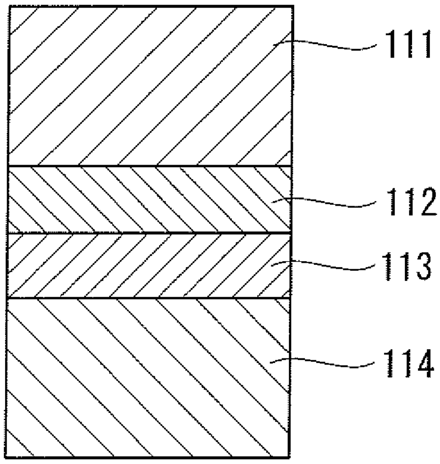
111
112
113
114

FIG. 13

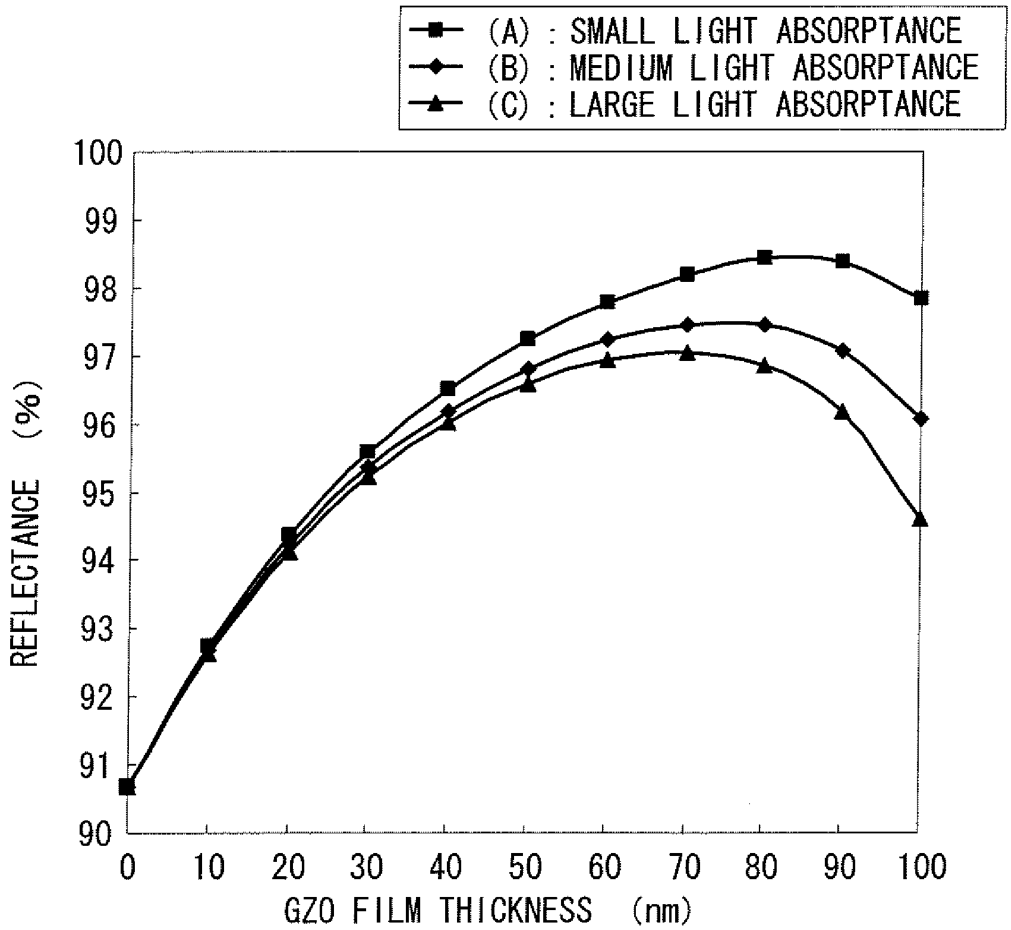
(A) : SMALL LIGHT ABSORPTANCE
(B) : MEDIUM LIGHT ABSORPTANCE
(C) : LARGE LIGHT ABSORPTANCE
REFLECTANCE (%)
100
99
98
97
96
95
94
93
92
91
90
0
10
20
30
40
50
60
70
80
90
100
GZO FILM THICKNESS (nm)

FIG. 14

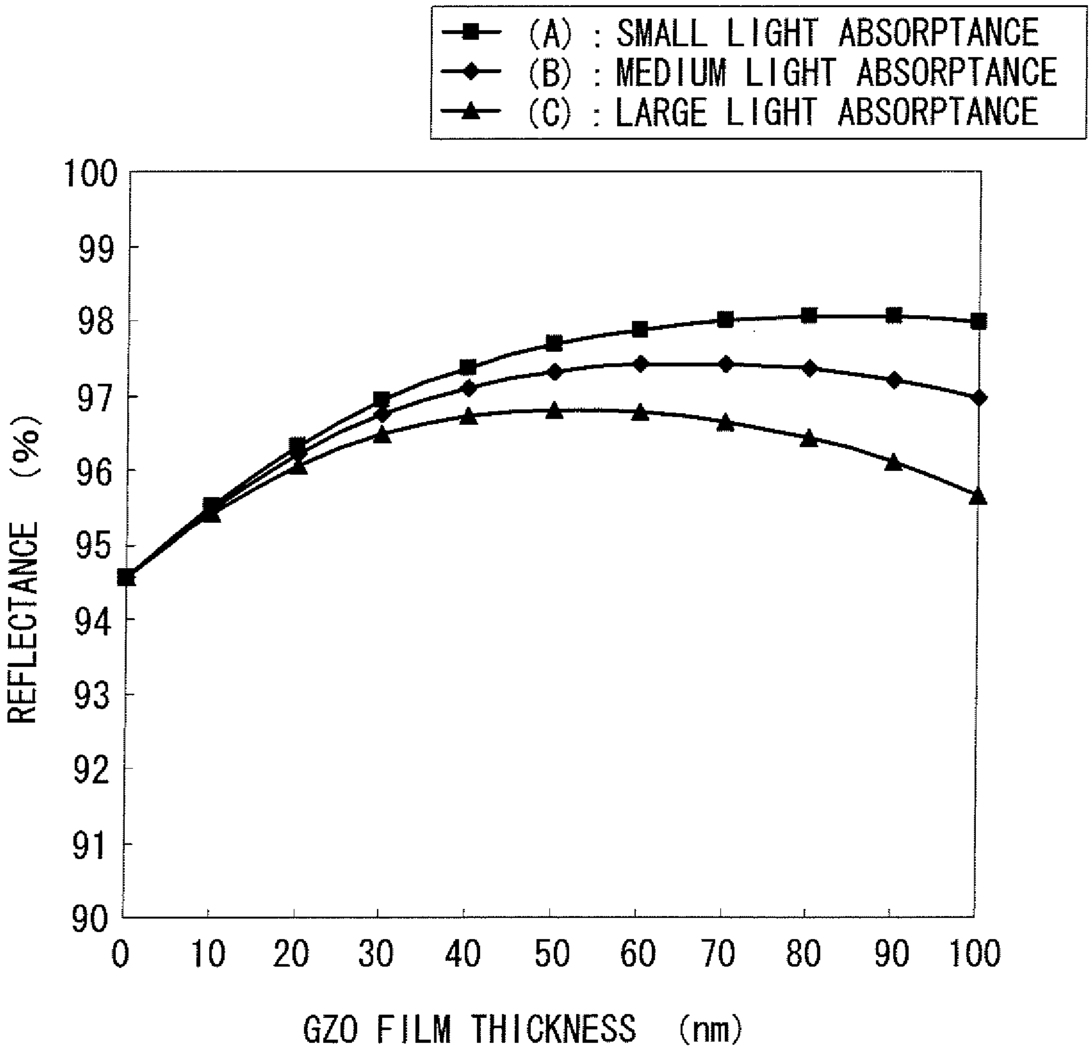
(A) : SMALL LIGHT ABSORPTANCE
(B) : MEDIUM LIGHT ABSORPTANCE
(C) : LARGE LIGHT ABSORPTANCE
100
99
98
97
96
95
94
93
92
91
90
REFLECTANCE (%)
0
10
20
30
40
50
60
70
80
90
100
GZO FILM THICKNESS (nm)

FIG. 15

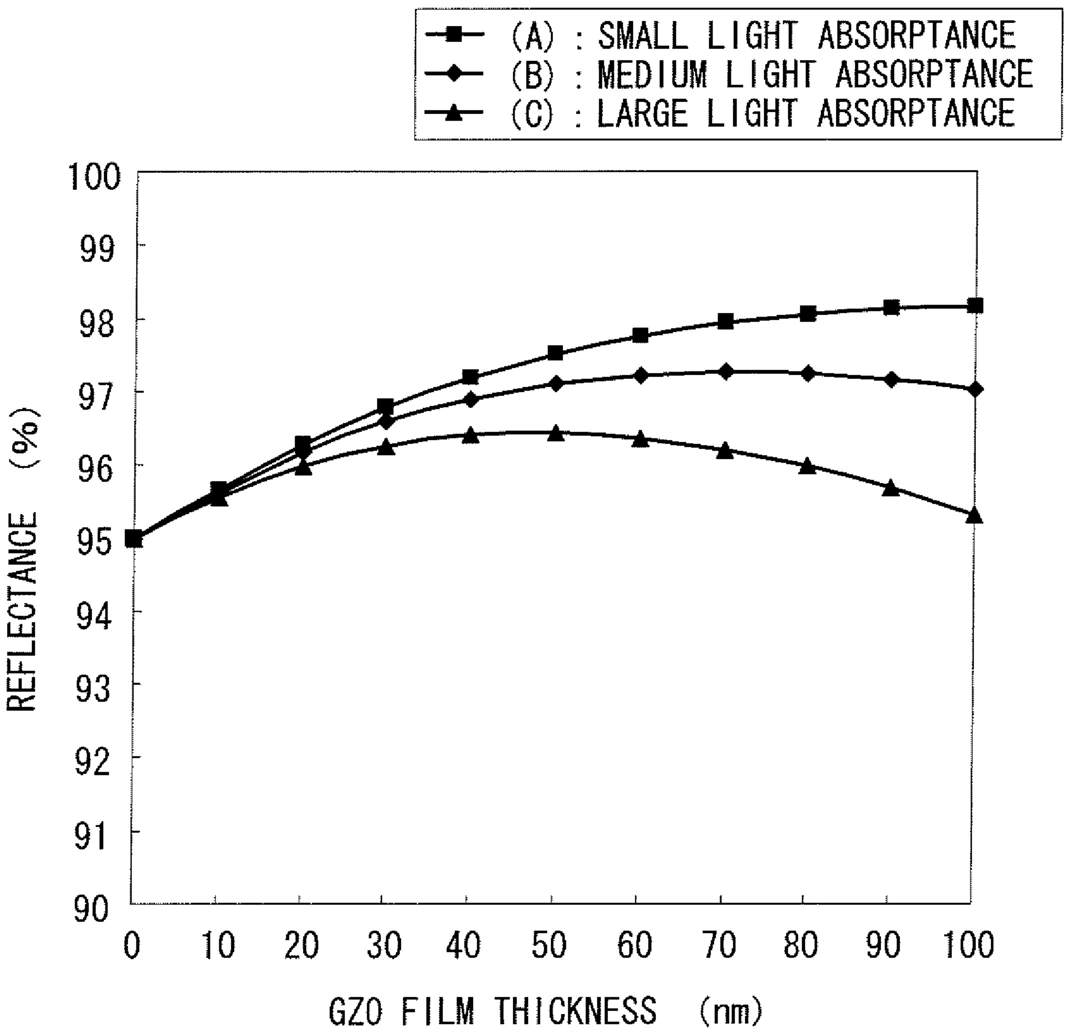
(A) : SMALL LIGHT ABSORPTANCE
(B) : MEDIUM LIGHT ABSORPTANCE
(C) : LARGE LIGHT ABSORPTANCE
REFLECTANCE (%)
100
99
98
97
96
95
94
93
92
91
90
0
10
20
30
40
50
60
70
80
90
100
GZO FILM THICKNESS (nm)

FIG. 16

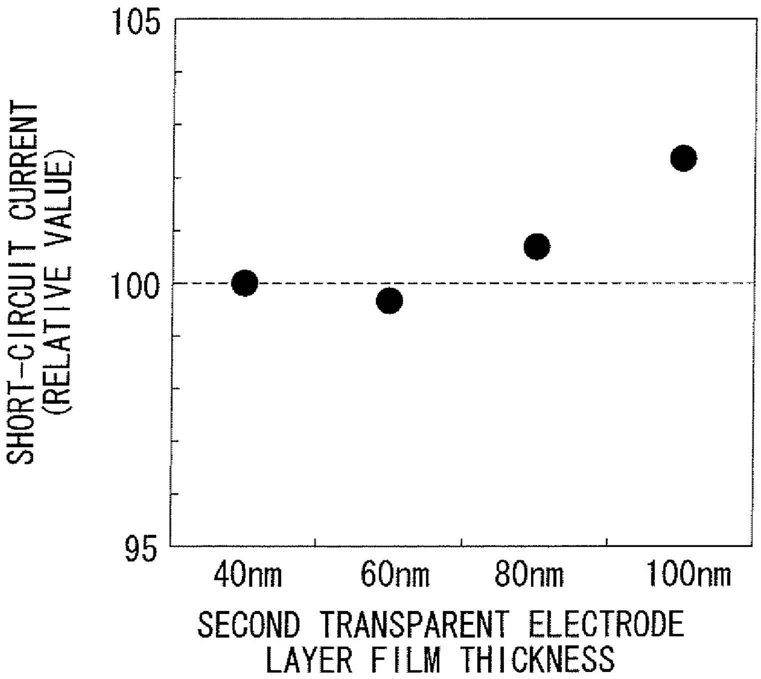
105
100
95
SHORT-CIRCUIT CURRENT
(RELATIVE VALUE)
40nm
60nm
80nm
100nm
SECOND TRANSPARENT ELECTRODE
LAYER FILM THICKNESS

FIG. 17

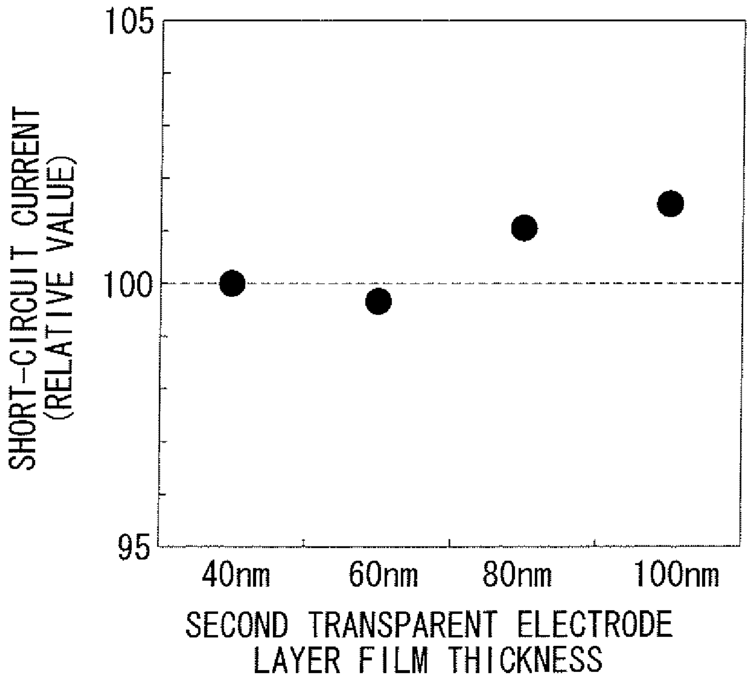
105
100
95
SHORT-CIRCUIT CURRENT
(RELATIVE VALUE)
40nm
60nm
80nm
100nm
SECOND TRANSPARENT ELECTRODE
LAYER FILM THICKNESS

**INTERNATIONAL SEARCH REPORT**

International application No.
PCT/JP2009/050098

A. CLASSIFICATION OF SUBJECT MATTER
*H01L31/04*(2006.01)i

According to International Patent Classification (IPC) or to both national classification and IPC

B. FIELDS SEARCHED

Minimum documentation searched (classification system followed by classification symbols)
H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2006-120737 A (Mitsubishi Heavy Industries, Ltd.), 11 May, 2006 (11.05.06), Par. Nos. [0024] to [0030] (Family: none) | 1-7 |
| X | JP 2000-150934 A (Sanyo Electric Co., Ltd.), 30 May, 2000 (30.05.00), Par. Nos. [0025], [0044] to [0051]; Fig. 1 (Family: none) | 1-7 |
| X | JP 11-274528 A (Sanyo Electric Co., Ltd.), 08 October, 1999 (08.10.99), Par. No. [0021]; Fig. 1 (Family: none) | 1-7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 January, 2009 (30.01.09) | 10 February, 2009 (10.02.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2009/050098

C (Continuation). DOCUMENTS CONSIDERED TO BE RELEVANT

| Category* | Citation of document, with indication, where appropriate, of the relevant passages | Relevant to claim No. |
|---|---|---|
| X | JP 2003-188401 A (Mitsubishi Heavy Industries, Ltd.), 04 July, 2003 (04.07.03), Par. No. [0028]; Fig. 1 (Family: none) | 1-7 |
| X | JP 2003-298088 A (Kaneka Corp.), 17 October, 2003 (17.10.03), Par. Nos. [0004], [0052]; Fig. 2 (Family: none) | 1-7 |
| A | JP 5-110125 A (Canon Inc.), 30 April, 1993 (30.04.93), Par. No. [0013] (Family: none) | 1-7 |
| A | JP 5-206490 A (Sharp Corp.), 13 August, 1993 (13.08.93), Full text; all drawings (Family: none) | 1-7 |
| A | JP 7-321362 A (Sanyo Electric Co., Ltd.), 08 December, 1995 (08.12.95), Full text; all drawings (Family: none) | 1-7 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP SHO6041878 B